Europäisches Patentamt

European Patent Office

Office européen des brevets

(11) Publication number: **0 404 940 A1**

# EUROPEAN PATENT APPLICATION
## published in accordance with Art. 158(3) EPC

(21) Application number: 89903809.5

(22) Date of filing: 23.03.89

(86) International application number:
PCT/JP89/00312

(87) International publication number:
WO 89/10593 (02.11.89 89/26)

(51) Int. Cl.⁵: **G06F 11/22, G06F 12/16, G11C 29/00**

(30) Priority: 28.04.88 JP 107357/88

(43) Date of publication of application:
02.01.91 Bulletin 91/01

(84) Designated Contracting States:
DE FR GB

(71) Applicant: FANUC LTD
3580, Shibokusa Aza-Komanba Oshinomura
Minamitsuru-gun Yamanashi 401-05(JP)

(72) Inventor: KURAKAKE, Mitsuo
Izumi Haitsu 103, 3-3-10, Tamadaira, Hino-shi
Tokyo 191(JP)
Inventor: YONEKURA, Mikio
Keio Takao Mansion 1103, 1231-36,
Hatsuzawamachi
Hachioji-shi, Tokyo 193(JP)

(74) Representative: Brunner, Michael John et al
GILL JENNINGS & EVERY 53-64 Chancery
Laneane
London WC2A 1HN(GB)

(54) **MEMORY TESTING SYSTEM.**

(57) A memory testing system for testing IC memories having pins directly soldered onto lands of a printed board. IC memories (3a, 3b, 3c, 3d) are mounted on a printed board (2) having pins (2a) or connectors that can be inserted in a socket or the like to constitute a memory module, and the testing is effected for each memory module. This makes it possible to test IC memories of the surface-mounted type.

F I G. 1

## DESCRIPTION

MEMORY TEST SYSTEM

TECHNICAL FIELD

The present invention relates to a system for testing a memory used in a numerically controlled apparatus (CNC) and the like, and more specifically, to a memory test system capable of testing individual memory modules.

BACKGROUND ART

A numerically controlled apparatus uses many IC memories, and because these IC memories are highly integrated components, they each must be tested before being mounted on a printed circuit board, to improve the reliability of an apparatus using these memories.

An IC memory is tested using an IC tester or the like, wherein the leads of the IC memory are directly inserted into a socket of the tester, and in this case, since an IC composed of a DIP has mechanically strong leads, no problem arises when it is mounted on a printed circuit board, even after the leads are inserted into the socket.

The leads of an IC composed of a SOP (small outline package), QFP (quad flat package) and the like, however, which is manufactured on the assumption that it will be soldered directly to a land or the like of a printed circuit board, have a relatively low mechanical strength, and accordingly, once the IC is mounted on the socket of the IC tester, it is difficult to assure that the leads are accurately positioned when the IC is mounted on a printed circuit board. Therefore, the IC memories composed of the SOP or QFP cannot be subjected to a total inspection, and thus a serious problem arises with respect to the reliability of an apparatus using this type of IC memories.

DISCLOSURE OF THE INVENTION

Taking the above into consideration, an object of the present invention is to provide a memory test system wherein IC memories composed of a SOP and QFP are arranged as memory modules and they are individually tested.

Therefore, to solve the above problem, in accordance with the present invention, there is provided a memory test system for testing IC memories having pins to be directly soldered to a land or the like on a printed circuit board, comprising the steps of arranging memory modules by mounting the IC memories on printed circuit boards each having pins, connectors or the like capable of being inserted in a socket or the like, and individually testing the memory modules.

Since memory modules each capable of being mounted to a socket or the like are arranged and tested individually, IC memories mounted thereon can be subjected to a total inspection using an IC tester, as for IC memories composed of a DIP.

BRIEF DESCRIPTION OF THE DRAWINGS

Figure 1 is an external view of a memory module to be tested by a memory test system according to the present invention;

Figure 2 is a diagram illustrating a test procedure of the memory test system and a following procedure for mounting the memory module to a numerically controlled apparatus, according to the present invention.

BEST MODE OF CARRYING OUT THE INVENTION

An embodiment of the present invention will be described below with reference to drawings.

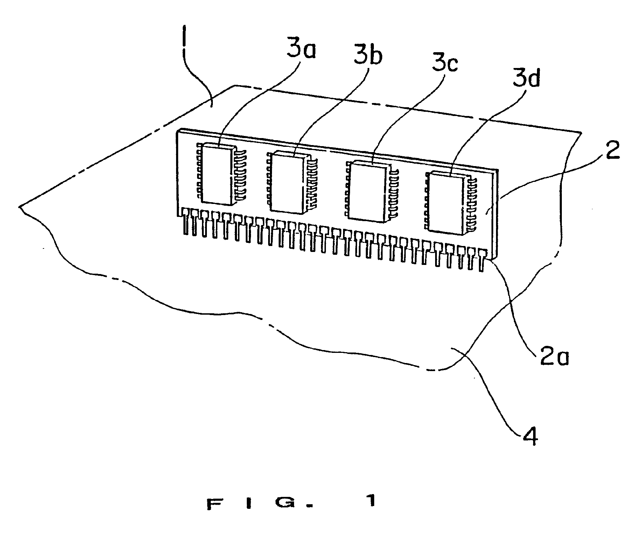

Figure 1 shows an external view of a memory module to be tested by a memory test system according to the present invention, wherein 1 designates a memory module; 2 designates a printed circuit board having an edge to which connecting pins 2a to be inserted into sockets are soldered; 3a - 3d designate IC memories composed of a SOP (small outline package) or QFP (quad flat package) using an SRAM of about 256 K bits. Since the IC memories 3a - 3d are a surface mount type, they are soldered to a not shown pad on the printed circuit board 2 by paste solder. Numeral 4 designates a mother board to which the tested module 1 is mounted through a socket or the like.

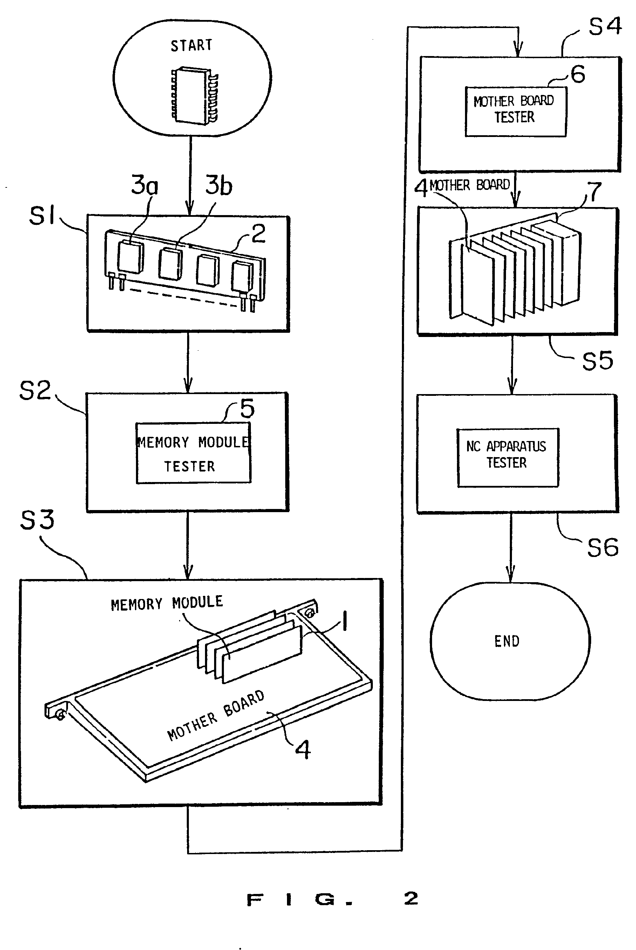

Next, the memory test system according to the present invention will be described with reference to Figure 2. Figure 2 shows a diagram of a test procedure of the memory test system and a following procedure for mounting the memory module to a numerically controlled apparatus, according to the present invention, wherein numerals prefixed with an S indicate the number of the steps of these procedures.

At S1, the IC memories composed of the SOP or QFP are soldered to the printed circuit board 2 to provide the memory module 1, and at S2, the memory module 1 is coupled with a memory module tester (an IC tester) 5, through a socket to be subjected to a total inspection, and at this step an unreliable memory, if any, is screened. At S3, the memory module 1 having passed the inspection is mounted on the mother board 4, and at S4, the mother board 4 is coupled with a mother board tester 6 and tested, and then, at S5, mounted on a numerically controlled apparatus 7. Thereafter, at S6, the numerically controlled apparatus 7 as a whole is tested.

With this manner, the arrangement of the IC memories of the SOP or QFP as a module capable of being mounted on a socket or the like enables the IC memories to be subjected to the total inspection using the IC tester or the like.

As described above, according to the present invention, since surface mount type IC memories composed of the SOP or QFP are arranged as a small module having pins, connectors or the like capable of being inserted into a socket or the like, and each memory is individually tested, the memories alone can be subjected to a total inspection using an IC tester, as for IC memories composed of a DIP package and the like, and therefore, the reliability of a numerically controlled apparatus using these memories can be improved.

## CLAIMS

1. A memory test system for testing IC memories having pins to be directly soldered to a land or the like on a printed circuit board, comprising the steps of:

arranging memory modules by mounting the IC memories on printed circuit boards each having pins, connectors or the like capable of being inserted in a socket or the like; and

individually testing said memory modules.

2. A memory test system according to claim 1, wherein said IC memories are composed of a SOP (small outline package) or a QFP (quad flat package).

3a   3b   3c   3d

1

2

2a

4

F I G . 1

START

S1

3a 3b

2

S2

MEMORY MODULE
TESTER

5

S3

MEMORY MODULE

MOTHER BOARD

I

4

S4

MOTHER BOARD
TESTER

6

4 MOTHER BOARD

7

S5

NC APPARATUS
TESTER

S6

END

F I G. 2

# INTERNATIONAL SEARCH REPORT

International Application No  PCT/JP89/00312

## I. CLASSIFICATION OF SUBJECT MATTER (if several classification symbols apply, indicate all) 6

According to International Patent Classification (IPC) or to both National Classification and IPC

Int.Cl$^4$   G06F11/22, G06F12/16, G11C29/00

## II. FIELDS SEARCHED

| Minimum Documentation Searched 7 | |
|---|---|
| Classification System | Classification Symbols |
| IPC | G06F11/22, G06F12/16, G11C29/00 |

Documentation Searched other than Minimum Documentation
to the Extent that such Documents are Included in the Fields Searched 8

## III. DOCUMENTS CONSIDERED TO BE RELEVANT 9

| Category * | Citation of Document, 11 with indication, where appropriate, of the relevant passages 12 | Relevant to Claim No. 13 |
|---|---|---|
| Y | JP, A, 62-3500 (NEC Corporation) 9 January 1987 (09. 01. 87) (Family: none) | 1, 2 |
| Y | JP, A, 58-115699 (Fujitsu Ltd.) 9 July 1983 (09. 07. 83) (Family: none) | 1, 2 |
| Y | JP, A, 56-153597 (NEC Corporation) 27 November 1981 (27. 11. 81) (Family: none) | 1, 2 |

* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| June 5, 1989 (05. 06. 89) | June 26, 1989 (26. 06. 89) |
| International Searching Authority | Signature of Authorized Officer |
| Japanese Patent Office | |

Form PCT/ISA/210 (second sheet) (January 1985)